(19) Europäisches Patentamt / European Patent Office / Office européen des brevets

(11) **EP 2 270 978 A1**

(12) **DEMANDE DE BREVET EUROPEEN**

(43) Date de publication:
**05.01.2011 Bulletin 2011/01**

(51) Int Cl.:
*H03F 3/08* (2006.01)  *H03F 3/00* (2006.01)
*H03F 3/72* (2006.01)

(21) Numéro de dépôt: **10184210.2**

(22) Date de dépôt: **19.03.2009**

(84) Etats contractants désignés:
**AT BE BG CH CY CZ DE DK EE ES FI FR GB GR HR HU IE IS IT LI LT LU LV MC MK MT NL NO PL PT RO SE SI SK TR**
Etats d'extension désignés:
**AL BA RS**

(30) Priorité: **19.03.2008 FR 0851764**

(62) Numéro(s) de document de la (des) demande(s) initiale(s) en application de l'article 76 CBE:
**09728333.7 / 2 260 575**

(71) Demandeur: **Commissariat à l'Énergie Atomique et aux Énergies Alternatives**
**75015 Paris (FR)**

(72) Inventeurs:
• **Audebert, Patrick**
  **38760 Varces Allieres et Risset (FR)**
• **Willemin, Jérôme**
  **38210 Tullins (FR)**

(74) Mandataire: **Vuillermoz, Bruno et al**
  **Cabinet Laurent & Charras**
  **"Le Contemporain"**
  **50, Chemin de la Bruyère**
  **69574 Dardilly Cédex (FR)**

Remarques:
Cette demande a été déposée le 30-09-2010 comme demande divisionnaire de la demande mentionnée sous le code INID 62.

(54) **Système de conversion de charges en tension et procédé de pilotage d'un tel système**

(57) L'invention concerne de pilotage d'un dispositif de conversion de charge en tension comportant un amplificateur et au moins une capacité montée en contre-réaction entre une entrée et une sortie dudit amplificateur, ledit amplificateur étant apte à être connecté entre au moins un étage d'entrée, pour recevoir de celui-ci une charge, et au moins un étage de sortie pour délivrer à celui-ci une tension représentative de la charge reçue en entrée, ledit procédé comportant au moins une phase de conversion en tension (62) d'une charge reçue sur l'entrée.

Selon l'invention la phase de conversion comporte au moins:
■ une première sous-phase (64) pendant laquelle l'amplificateur est connecté à l'étage d'entrée et l'amplificateur est déconnecté de l'étage de sortie ;
■ suivie, d'une seconde sous-phase (66) pendant l'amplificateur est déconnecté de l'étage d'entrée et l'amplificateur est connecté à l'étage de sortie.

**Fig. 18**

**Description**

**DOMAINE DE L'INVENTION**

La présente invention a trait au domaine de conversion de charges.

Plus particulièrement, l'invention concerne un procédé de pilotage d'un dispositif de conversion de charges comportant un amplificateur et au moins une capacité montée en contre-réaction entre une entrée et une sortie dudit amplificateur, ledit amplificateur étant apte à être connecté entre au moins un étage d'entrée, pour recevoir de celui-ci une charge, et au moins un étage de sortie pour délivrer à celui-ci une tension représentative de la charge d'entrée, ledit procédé comportant au moins une phase de conversion de la charge reçue sur l'entrée en tension.

**ETAT ANTERIEUR DE LA TECHNIQUE**

L'amplification de charge au moyen d'un amplificateur opérationnel contre-réactionné par une capacité est utilisée dans de nombreuses applications de lecture, comme par exemple la lecture d'une tension, la lecture d'une capacité ou encore la lecture d'un paquet de charges.

Comme cela est connu en soi, un amplificateur opérationnel présente un gain en tension limité dans la gamme définie de ses tensions d'alimentations. Le gain est en outre limité à une plage de fréquences, l'amplificateur présentant usuellement un gain du type passe-bas. De plus, cette plage de fréquences dépend de l'impédance des charges connectées en entrée et en sortie de l'amplificateur, charges qui influencent donc la durée d'établissement du signal amplifié en sortie de l'amplificateur.

Pour pallier ces inconvénients, une impédance est classiquement montée en contre-réaction entre l'entrée inverseuse et la sortie de l'amplificateur, de manière à ce que la fonction de transfert du système ainsi bouclé ne dépende pas de manière prépondérante de cette impédance.

Lorsque l'impédance de contre-réaction est une capacité, on parle alors d'une amplification de charge. En effet, un amplificateur opérationnel contre-réactionné par une capacité réalise une amplification des charges qu'il reçoit en entrée.

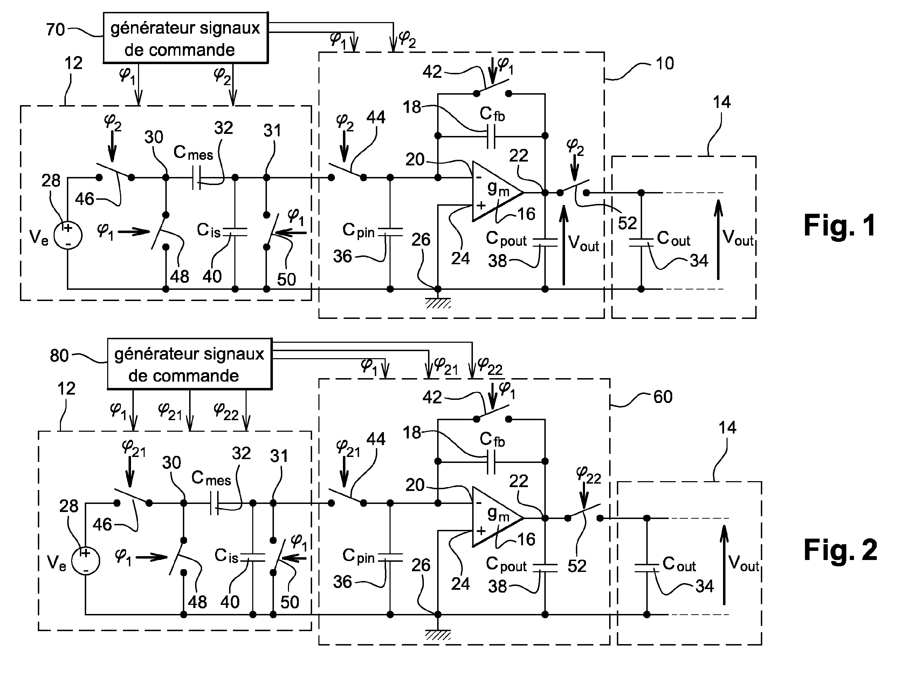

On a illustré sur la figure 1 un dispositif de conversion de charge en tension **10** de l'état antérieur de la technique. Ce dispositif d'amplification **10** est connecté en entrée à un étage d'entrée **12** et en sortie à un étage de sortie **14.**

Le dispositif de conversion **10** comprend un amplificateur opérationnel **16,** de transconductance $g_m$, et une capacité de contre-réaction **18,** de valeur $C_{fb}$, connectée entre la borne inverseuse **20** et la borne de sortie **22** de celui-ci. La borne non inverseuse **24** de l'amplificateur **16** est quant à elle connectée à un potentiel de référence, comme une masse **26** par exemple.

L'étage d'entrée **12** comporte une source de tension **28,** connectée entre la masse **26** et une borne **30** et de valeur $V_e$, ainsi qu'une capacité de conversion de tension **32,** connectée entre les bornes **30** et **31,** de valeur $C_{mes}$.

L'étage de sortie **14** comporte quant à lui une capacité équivalente d'entrée **34** de valeur $C_{out}$ et connectée entre la borne de sortie **22** de l'amplificateur **16** et la masse **26.**

Dans le schéma de la figure 1, des capacités parasites **36, 38, 40** sont également illustrées. Ces capacités sont générées par la structure des transistors, par exemple de technologie MOS, constituant l'amplificateur **16,** ainsi que par les différentes interconnexions (pistes, fils, soudures métalliques...) qui existent dans, et entre, les divers éléments venant d'être décrits.

Classiquement, ces capacités parasites **36, 38, 40** sont modélisées par :

■ une capacité parasite d'entrée **36** de l'amplificateur **16** de valeur $C_{pin}$. Cette capacité parasite **36** est connectée entre la borne inverseuse **20** de celui-ci et la masse **26 ;**
■ une capacité parasite de sortie **38** de l'amplificateur **16** de valeur $C_{pout}$. Cette capacité parasite **38** est connectée entre la borne de sortie de celui-ci et la masse **26 ;**
■ et une capacité parasite **40** des connexions de l'étage d'entrée, de valeur $C_{is}$. Cette capacité parasite **40** est connectée en parallèle à la capacité parasite d'entrée **36** de l'amplificateur.

Des interrupteurs pilotables **42, 44, 46, 48, 50, 52** sont également prévus, un premier interrupteur **42** étant connecté en parallèle à la capacité de contre-réaction **18,** un deuxième interrupteur **44** étant connecté en entrée de l'amplificateur **16** entre la borne inverseuse **20** et la borne **31** de la capacité **32** de l'étage d'entrée **12,** un troisième interrupteur **46** étant connecté entre cette capacité **32** et la source de tension **28,** un quatrième interrupteur **48** étant connecté entre la borne **30** de l'étage d'entrée et la masse **26,** un cinquième interrupteur **50** étant connecté entre la borne **31** de l'étage d'entrée et la masse **26,** et un sixième interrupteur **52** étant connecté entre la sortie **22** de l'amplificateur **16** et la capacité équivalente d'entrée **34** de l'étage de sortie **14.**

Les interrupteurs **42, 44, 46, 48, 50, 52** sont pilotés par un générateur **70** de deux signaux de commande $\varphi_1$,

$\varphi_2$ selon une stratégie d'ouverture et de fermeture décrite ci-après, le signal $\varphi_1$ commandant l'ouverture et la fermeture des interrupteurs **42, 48** et **50,** et le signal $\varphi_2$ commandant l'ouverture et la fermeture des interrupteurs **44, 46** et **52.**

Selon la nature des interrupteurs, le générateur **70** sera éventuellement amené à délivrer des signaux complémentaires d'un point de vue logique binaire, en particulier pour la commande d'interrupteurs CMOS.

La figure 1 illustre par exemple une amplification de la tension $V_e$ au moyen d'une amplification de charge.

Dans un premier temps, les premier, quatrième et cinquième interrupteurs **42, 48** et **50** sont fermés et les deuxième, troisième et sixième interrupteurs **44, 46, 52** sont ouverts. Les capacités de contre-réaction **18** et de conversion de tension **32** sont ainsi déchargées.

Dans un second temps, les premier, quatrième et cinquième interrupteurs **42, 48** et **50** sont ouverts et les deuxième, troisième et sixième interrupteurs **44, 46, 52** sont fermés. La tension $V_e$ aux bornes de la source **28** est ainsi convertie en une charge $Q_e$ par la capacité de conversion de tension **32,** et une charge équivalente $Q_e'$ ($=Q_e$) est générée aux bornes de la capacité de contre-réaction **18** par conservation de la charge sur l'entrée non-inverseuse **20** de l'amplificateur **16.** Cette charge $Q_e'$ est convertie en tension $V_{out}$ par l'intermédiaire de la capacité de contre-réaction **18.** Cette tension $V_{out}$ est observable aux bornes des capacités $C_{pout}$ **38** et $C_{out}$ **34.**

La fonction de transfert entre tension $V_{out}$ amplifiée et la tension $V_e$ est ainsi donnée par la relation suivante :

$$G(s) = \frac{C_{mes}R_{out}\left(-g_m + C_{fb}s\right)}{\left(C_{mes} + C_{is} + C_{pin}\right)\left(1 + \left(C_{out} + C_{pout}\right)R_{out}s\right) + C_{fb}\left(1 + R_{out}\left(C_{mes} + C_{out} + C_{pout} + C_{pin} + C_{is}\right)s\right)} \tag{1}$$

où s est la variable de Laplace et $R_{out}$ l'impédance de sortie de l'amplificateur opérationnel **16.**

La fonction de transfert G(s) est donc du type passe-bas du premier ordre.

Le gain en continu $G_0$ de la fonction G(s) est donné par la relation :

$$G_0 = -\frac{C_{mes}g_m R_{out}}{C_{mes} + C_{pin} + C_{is} + C_{fb}\left(1 + g_m R_{out}\right)} \tag{2}$$

La fréquence de coupure $\omega_c$ est par ailleurs égale à :

$$\omega_c = \frac{g_m}{C_{eq}} \tag{3}$$

où $C_{eq}$ est une capacité selon la relation :

$$C_{eq} = \frac{\left(C_{pout} + C_{out}\right)\left(C_{mes} + C_{pin} + C_{is}\right) + C_{fb}\left(C_{pout} + C_{out} + C_{mes} + C_{pin} + C_{is}\right)}{C_{fb}} \tag{4}$$

On notera que la capacité $C_{eq}$ peut se réécrire selon la relation :

$$C_{eq} = \frac{C_S C_E + C_{fb}\left(C_S + C_E\right)}{C_{fb}} \tag{5}$$

où $C_E = C_{mes} + C_{pin} + C_{is}$ est la capacité vue en entrée par l'amplificateur **16** et $C_S = C_{pout} + C_{out}$ est la capacité vue en sortie par l'amplificateur **16**.

En considérant les relations (2) et (3), on remarque ainsi que pour augmenter la bande passante de l'amplification et donc la rapidité de celle-ci (la durée d'établissement d'un signal en sortie de l'amplificateur est d'autant plus faible que la pulsation de coupure $\omega_c$ est grande), il faut maximaliser $\omega_c$.

Pour ce faire, il est possible de minimiser la capacité équivalente $C_{eq}$ ou de maximiser la transconductance $g_m$ de l'amplificateur **16**.

Toutefois, l'augmentation de la transconductance $g_m$ implique d'utiliser un amplificateur à forte consommation d'énergie. En outre, une augmentation de la transconductance $g_m$ induit également pour l'amplificateur une géométrie de transistors présentant des capacités parasites $C_{pin}$ et $C_{pout}$ plus importantes. La capacité équivalente $C_{eq}$ est alors plus importante et la pulsation de coupure $\omega_c$ plus petite.

L'augmentation de la bande passante peut également être réalisée par une minimisation de la capacité équivalente $C_{eq}$.

Pour baisser la valeur de celle-ci, il est possible de maximiser la valeur de la capacité de contre-réaction $C_{fb}$. Or, maximaliser $C_{fb}$ a pour effet de diminuer le gain en continu $G_0$, ce qui est contraire au premier but recherché, à savoir l'amplification.

C'est pourquoi, une maximisation de la bande passante est usuellement recherchée et obtenue par une minimisation des capacités parasites $C_{pin}$ et $C_{pout}$. Des études sur la structure et la géométrie des transistors constituant l'amplificateur **16** ont ainsi été réalisées. De telles études sont cependant longues et complexes dans la mesure où elles concernent la conception de transistors.

Par ailleurs, quand bien même les capacités parasites seraient optimisées, la capacité équivalente $C_{eq}$ dépend toujours des étages d'entrée **12** et de sortie **14**, et notamment des capacités $C_{mes}$, $C_{is}$ et $C_{out}$. Le gain en bande passante, et donc en durée d'établissement, est limité par la présence de ces capacités. De même, il existe toujours des capacités parasites en entrée et en sortie de l'amplificateur qui ne sont pas liées à l'amplificateur lui-même. On peut notamment citer les capacités parasites des connexions de l'amplificateur **16** avec les étages d'entrée **12** et de sortie **14.**

On notera que les problèmes exposés ci-dessus se posent de la même manière dans d'autres applications de l'amplification de charge. Par exemple, on notera également que la figure 1 illustre la lecture de la valeur $C_{mes}$ de la capacité **32** dont la valeur est inconnue.

Dans une telle application la valeur de la tension $V_e$ est connue et la tension $V_{out}$ aux bornes de la capacité de conversion de charge **34** mesurée. La fonction de transfert entre la tension $V_{out}$ et la capacité $C_{mes}$ est alors donnée par la relation :

$$G_0 = \frac{V_e g_m R_{out}}{C_{mes} + C_{pin} + C_{is} + C_{fb}\left(1 + g_m R_{out}\right)} \quad (2C)$$

Cette fonction de transfert également de type passe-bas avec une pulsation de coupure analogue à celle de la relation (3). Une telle application est par exemple décrite dans le document de N. Yazdi et al. «Precision readout circuits for capacitive microaccelerometers», Sensors 2004, Proceedings of IEEE.

On notera qu'une telle application consiste généralement à mesurer les variations de la capacité de conversion de tension **32** ($C_{mes}$) autour d'une valeur de référence très supérieure auxdites variations. Ceci implique notamment de choisir la capacité de contre-réaction **18** du même ordre de grandeur que les variations de la capacité **32,** de sorte que la capacité équivalente est sensiblement égale à $C_{eq} = \dfrac{C_S C_E}{C_{fb}}$. L'influence des capacités parasites sur la bande passante de l'amplification s'en retrouve donc renforcée.

Ces problèmes se posent également dans le cas de conversion en tension de paquets de charges issus de plusieurs étages d'entrée qui partage un même dispositif de conversion. Les étages d'entrée sont par exemple les pixels d'une colonne d'un capteur matriciel tel qu'un capteur d'image CCD ou CMOS, qui délivre périodiquement sur un bus colonne des paquets de charges à convertir en tension.

De manière analogue aux applications précités, la fonction de transfert entre la tension $V_{out}$ et un paquet de charges reçu $Q_e$ est du type passe-bas selon la relation :

$$G_0 = \frac{g_m R_{out}}{C_{mes} + C_{pin} + C_{is} + C_{fb}\left(1 + g_m R_{out}\right)} \qquad (2Q)$$

La pulsation de coupure de cette fonction de transfert est donc analogue à celle de la relation (3). On notera que dans cette application, la capacité parasite liée à la connectique du bus colonne est très importante, limitant de fait la bande passante de conversion en tension des paquets de charges incidents.

Le but de la présente invention est de résoudre le problème susmentionné en proposant un procédé de pilotage du dispositif de conversion qui permette un gain significatif en bande passante, et donc en temps d'établissement, et cela en modifiant à minima la structure, le fonctionnement ou l'agencement de l'amplificateur ou des étages d'entrée et de sortie, et sans avoir une diminution du gain final de conversion.

**EXPOSE DE L'INVENTION**

A cet effet, l'invention a pour objet un procédé de pilotage d'un dispositif de conversion de charges comportant un amplificateur et au moins une capacité montée en contre-réaction entre une entrée et une sortie dudit amplificateur, ledit amplificateur étant apte à être connecté entre au moins un étage d'entrée, pour recevoir de celui-ci une charge, et au moins un étage de sortie pour délivrer à celui-ci une tension représentative de la charge incidente reçue, ledit procédé comportant au moins une phase de conversion de la charge reçue sur l'entrée en tension.

Selon l'invention, la phase de conversion comporte au moins :

■ une première sous-phase pendant laquelle l'amplificateur est connecté à l'étage d'entrée et l'amplificateur est déconnecté de l'étage de sortie ;
■ suivie, d'une seconde sous-phase pendant laquelle l'amplificateur est déconnecté de l'étage d'entrée et l'amplificateur est connecté à l'étage de sortie.

En d'autres termes, on isole tour à tour l'amplificateur des capacités de l'étage d'entrée et de l'étage de sortie. Lors de chacune des sous-phases, la capacité équivalente ainsi obtenue est inférieure à la capacité équivalente $C_{eq}$. Le temps d'établissement cumulé de ces deux sous-phases est ainsi inférieur à celui usuellement constaté lors de la mise en oeuvre de la phase d'amplification de l'état de la technique.

Selon des modes de réalisation particuliers de l'invention, le procédé comporte une ou plusieurs des caractéristiques suivantes :

■ les durées de deux sous-phases sont sensiblement identiques ;
■ les durées de deux sous-phases sont réglées en fonction des constantes de temps des ensembles formés, d'une part, du dispositif d'amplification connecté à l'étage d'entrée, et d'autre part, du dispositif d'amplification connecté à l'étage de sortie ;
■ le ou chaque amplificateur est un amplificateur opérationnel dont l'entrée inverseuse et la sortie sont montées en contre-réaction par une capacité ;
■ le ou chaque amplificateur est un amplificateur opérationnel différentiel, dont chaque entrée est montée en contre-réaction avec une sortie de l'amplificateur au moyen d'une capacité ;

L'invention a également pour objet un système d'amplification de charges. Celui-ci comprend :

■ un dispositif d'amplification comprenant un amplificateur et au moins une capacité montée en contre-réaction entre une entrée et une sortie dudit amplificateur, ledit amplificateur étant apte à être connecté entre au moins un étage d'entrée, pour recevoir de celui-ci une charge, et au moins un étage de sortie pour délivrer à celui-ci une tension représentative de la charge reçue sur l'entrée ;
■ un premier élément pilotable apte à décharger la capacité de contre-réaction,
■ un deuxième élément pilotable apte à déconnecter l'amplificateur de l'étage d' entrée ;
■ un dispositif de pilotage apte à piloter les premier et deuxième éléments pilotables selon une phase de décharge de la capacité de contre-réaction, et une phase d'amplification d'une charge reçue de l'étage d'entrée par l'amplificateur.

Selon l'invention :

- l'emplacement de la connexion et de la déconnexion de l'amplificateur à l'étage d'entrée et/ou l'emplacement de la connexion et de la déconnexion de l'amplificateur à l'étage de sortie est localisé au plus près de l'amplificateur ;
- le système comporte en outre un troisième élément pilotable apte à déconnecter l'amplificateur de l'étage de sortie, le dispositif de pilotage étant apte, lors de la phase d'amplification, au moins :

  ■ à piloter le deuxième élément pilotable pour connecter l'amplificateur à l'étage d'entrée et à piloter le troisième élément pilotable pour déconnecter l'amplificateur de l'étage de sortie;
  ■ puis, à piloter le deuxième élément pilotable pour déconnecter l'amplificateur de l'étage d'entrée et à piloter le troisième élément pilotable pour connecter l'amplificateur à l'étage de sortie.

En d'autres termes, ce système met en oeuvre le procédé précité.

Selon l'invention, l'étage d'entrée comprend une colonne d'une matrice d'éléments de détection, le dispositif de conversion de charge étant apte à être connecté à chacun des éléments de détection de ladite colonne pour recevoir de celui-ci une charge.

En d'autres termes, les circuits de lecture de matrice d'imagerie de l'état de la technique comprennent usuellement des dispositifs de conversion de charge en bout de chaque colonne de la matrice pour convertir séquentiellement les charges électriques produites par les éléments unitaires de détection, ou pixels, de la colonne Or, les dispositifs de conversion de charges de l'état de la technique restent constamment connectés aux bus colonne par lequel transitent les charges en provenance des pixels. De tels bus colonne présentent usuellement une capacité parasite très élevée et d'autant plus importante que la matrice est de grandes dimensions. Ceci induit une durée de lecture très importante des charges produites en raison d'une capacité équivalente élevée. La déconnexion des dispositifs de charge de ces bus colonne lors de l'établissement des tensions en sortie des dispositifs de conversion a ainsi pour effet une augmentation significative de la vitesse d'établissement.

On observe alors, en gardant la durée d'une trame de lecture de l'état de la technique, une conversion et un transfert total de la charge à l'étage de sortie.

Selon un mode de réalisation de l'invention, le premier élément pilotable et/ou le deuxième élément pilotable est placé au plus près de l'amplificateur.

En d'autres termes, le maximum d'éléments sont connectés et déconnectés de l'amplificateur, et notamment la connectique reliant l'amplificateur à l'étage d'entrée et à l'étage de sortie. On sait en effet que cette connectique présente usuellement une grande capacité parasite. En procédant à une connexion et une déconnexion au plus près des éléments physiques effectivement en charge de l'amplification, la capacité équivalente est alors optimisée.

**BREVE DESCRIPTION DES FIGURES**

La présente invention sera mieux comprise à la lecture de la description qui va suivre, donnée uniquement à titre d'exemple, est réalisée en relation avec les dessins annexées dans lesquels, des références identiques désignent des éléments identiques ou analogues, et dans lesquels :

- la figure 1 est une vue schématique d'un dispositif de conversion de charge par capacités commutées de l'état antérieur de la technique déjà décrite dans le préambule ;
- la figure 2 est une vue schématique d'un dispositif de conversion de charge par capacités commutées selon un premier mode de réalisation de l'invention ;
- la figure 3 est un organigramme d'un procédé selon l'invention ;
- les figures 4 à 7 sont des graphiques de courbes illustrant les différentes phases de l'amplification de charge selon l'invention et l'état de la technique de la figure 1.
- la figure 8 est une vue schématique d'un convertisseur de charges de l'état de la technique associé à une matrice de pixels agencés en L lignes et C colonnes ;
- la figure 9 est un organigramme d'un procédé de commande d'un dispositif de conversion de charge entrant dans la constitution du convertisseur de charge de la figure 8 ;
- les figures 10 à 17 sont des chronogrammes de signaux de pilotage d'interrupteurs entrant dans la constitution du convertisseur de charge de la figure 8 ;
- la figure 18 est une vue schématique d'un convertisseur de charges selon l'invention associé à une matrice de pixels agencés en L lignes et C colonnes .
- la figure 19 est un organigramme d'un procédé de commande d'un dispositif de conversion de charge entrant dans la constitution du convertisseur de charge de la figure 18 ;
- les figures 20 à 28 sont des chronogrammes de signaux de pilotage d'interrupteurs entrant dans la constitution du convertisseur de charge selon l'invention de la figure 18 ;
- les figures 29 à 34 sont des graphiques de courbes illustrant les différentes phases de l'amplification de charge par un convertisseur de charges selon l'invention et par un convertisseur de charge selon l'état de la technique ; et

- la figure 35 est une vue schématique d'un dispositif de conversion de charges différentiel par capacités commutées selon l'invention.

**DESCRIPTION DETAILLEE DE L'INVENTION**

Sur la figure 2, un dispositif de conversion de charge **60** selon l'invention est connecté en entrée à l'étage d'entrée **12** et en sortie à l'étage de sortie **14**. L'agencement de la figure 2 illustre par exemple l'amplification de la tension $V_e$ ou la mesure de variations de la capacité de conversion de tension **32,** comme cela a été expliqué plus en détail ci-dessus.

Dans une application avantageuse de l'invention, l'étage d'entrée **12** est un dispositif micro-électro-mécanique (ou MEMS) ou un dispositif nano-électro-mécanique (ou NEMS). Par exemple, l'étage d'entrée **12** est formé d'un accéléromètre ou un gyromètre dont la capacité **32,** formée de peignes interdigités dont l'un au moins est mobile, varie dans le temps. Le dispositif de conversion de charge **60** est avantageusement réalisé dans la même technologie, MEMS ou NEMS, que l'étage d'entrée **12**.

Le dispositif de conversion de charge **60** diffère du dispositif **10** de l'état de la technique, décrit ci-dessous en relation avec la figure 1, en ce qu'il est associé à un générateur **80** d'au moins trois signaux distincts de commande $\varphi_1$, $\varphi_{21}$, $\varphi_{22}$ des interrupteurs **42, 44, 46, 48 , 50** et **52,** le signal $\varphi_1$ commandant l'ouverture et la fermeture des interrupteurs **42, 48** et **50,** le signal $\varphi_{21}$ commandant l'ouverture et la fermeture des interrupteurs **44** et **46,** et le signal $\varphi_{22}$ commandant l'ouverture et la fermeture de l'interrupteur **52**.

Selon la nature des interrupteurs le générateur **80** sera éventuellement amené à délivrer des signaux complémentaires d'un point de vue logique binaire, en particulier pour la commande d'interrupteur CMOS.

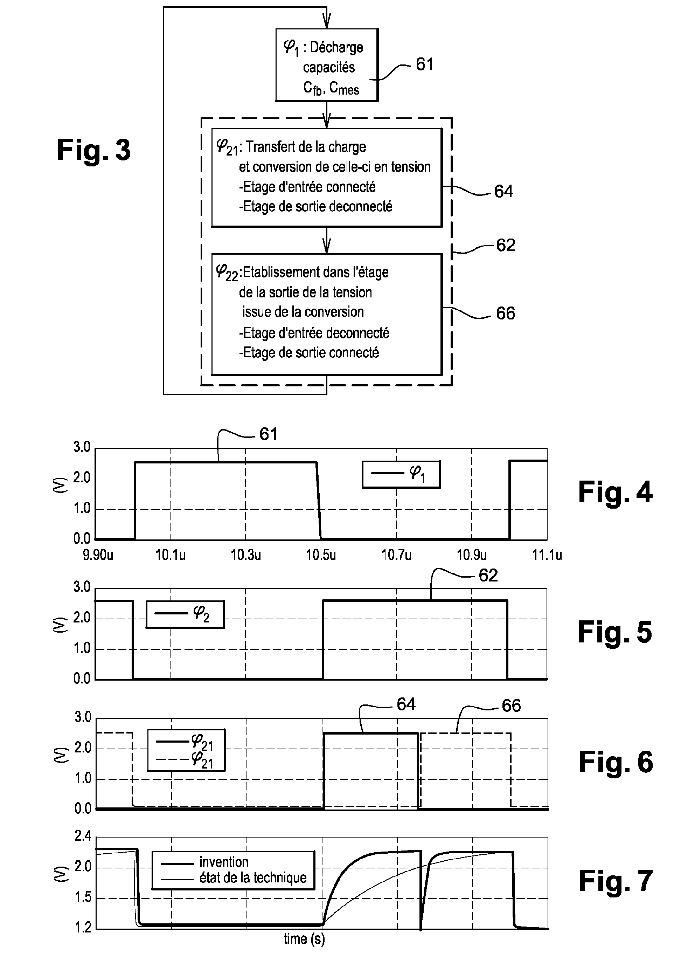

Le procédé de pilotage des interrupteurs **42, 44, 46, 48, 50** et **52** mis en oeuvre par le générateur **80** est illustré par l'organigramme de la figure 3.

Lors d'une première étape **61,** analogue à celle de l'état de la technique, les premier, troisième et cinquième interrupteurs **42, 48, 50** sont fermés et les deuxième, quatrième et sixième interrupteurs **44, 46, 52** sont ouverts. Toutes les capacités **18, 32, 36, 38, 40** sont ainsi déchargées.

La phase de décharge de l'étape **61** est alors suivie, en **62,** d'une phase de conversion de charge.

Dans une première sous-phase **64** de la phase de conversion **62,** les premier, troisième et cinquième interrupteurs **42, 48, 50** sont ouverts, et les deuxième et quatrième interrupteurs **44, 46** sont fermés. Le cinquième interrupteur **52** est laissé ouvert, la borne de sortie **22** de l'amplificateur **16** étant de ce fait déconnectée de l'étage de sortie **14**.

Ainsi, la tension $V_e$ est convertie en une charge $Q_e$ par la capacité de conversion de tension **32,** et la charge $Q_e$ est convertie par l'amplificateur contre-réactionné **16, 18**. La charge converti est stockée dans la capacité de contre-réaction **18,** générant ainsi la tension $V_{out}$ sur la borne de sortie **22**.

Dans une seconde sous-phase **66,** les deuxième et quatrième interrupteurs **44, 46** sont ouverts, déconnectant de ce fait l'entrée non-inverseuse **20** de l'amplificateur **16** de l'étage d'entrée **12**. Le cinquième interrupteur **52** est quant à lui fermé, connectant de ce fait la sortie de l'amplificateur **16** à l'étage de sortie **14**

La tension $V_{out}$ générée aux bornes de la capacité de contre-réaction **18** est ainsi transférée à l'étage de sortie **14,** c'est-à-dire ici stockée dans la capacité $C_{out}$ **34** de celui-ci.

L'étape de conversion **62** reboucle alors sur l'étape **61** pour un nouveau cycle d'amplification de la tension $V_e$ ou de la lecture, sous forme de tension, de la capacité $C_{mes}$ **32.**

Les trois étapes **61, 64** et **66** mises en oeuvre par le générateur **80** n'ont jamais d'instant en commun. Ces trois étapes sont toujours entrecoupées par une petite fraction de temps pendant laquelle tous les interrupteurs sont ouverts afin de gérer rigoureusement, c'est-à-dire sans perte, les différents transferts de charges.

Les figures 4 à 7 illustrent des cycles de lecture de la capacité de conversion de tension **32,** selon l'état de la technique et selon l'invention. La capacité **32** est par exemple celle du capteur MEMS tel que décrit dans le document de Yadzi précité.

Les caractéristiques classiques d'un tel MEMS sont de 1 picofarad pour la valeur $C_{mes}$ de la capacité **32,** de 5 picofarads pour la valeur $C_{is}$ de la capacité parasite **40,** et les variations $\Delta C_{mes}$ de la valeur $C_{mes}$ que l'on cherche à mesurer sont de l'ordre de 100 femtofarads.

Les caractéristiques du dispositif de conversion, par exemple décrites dans le document de Yadzi, sont de 100 femtofarads pour la valeur $C_{pin}$ de la capacité parasite **36,** de 100 femtofarads pour la valeur $C_{fb}$ de la capacité de contre-réaction **18,** de 300 µA/V pour la valeur $g_m$ de la transconductance de l'amplificateur **16** et de 1 picofarad pour la valeur $C_{out}$ de la capacité **34** et 100 femtofarads pour la valeur $C_{pout}$ de la capacité **38**.

Avec ces valeurs, la capacité équivalente $C_{eq}$ est alors égale à 73,6 picofarads, ce qui définit un établissement de 87% de la tension $V_{out}$ lorsque les phases $\varphi_1$ et $\varphi_2$ de l'état de la technique sont égales chacune à 500ns, soit une fréquence d'échantillonnage de 1MHz pour la lecture des variations $\Delta C_{mes}$

Les sous-phases **64** et **66** selon l'invention sont quant à elles ici choisies de durée égale, c'est-à-dire d'une durée de 250 nanosecondes chacune.

La figure 4 illustre tant pour l'état de la technique que pour l'invention, le signal $\varphi_1$ de pilotage des interrupteurs **42, 48** et **50.** La valeur de 2,5 volts d'un signal de pilotage correspond ici à un ordre de fermeture des interrupteurs correspondants.

La figure 5 illustre, pour l'agencement de la figure 1 de l'état de la technique, le signal de pilotage $\varphi_2$ des interrupteurs **44 , 46** et **52.**

La figure 6 illustre, pour l'agencement de la figure 2 selon l'invention, le signal de pilotage $\varphi_{21}$ des interrupteurs **44** et **46** et le signal de pilotage $\varphi_{22}$ de l'interrupteur **52.**

La figure 7 illustre la tension à la borne de sortie **22** de l'amplificateur selon l'état de la technique (courbe en traits discontinus) et selon l'invention (trait continu).

Comme on peut le constater sur la figure 7, dans l'état de la technique, le temps d'établissement de la tension $V_{out}$ est trop long pour que la totalité de la charge Qe lue soit convertie et disponible simultanément sur la capacité **34** de l'étage de sortie **14.** A la fin de la phase de conversion, (basculement du signal $\varphi_2$ de la valeur 2,5 volts à la valeur 0 volts), seulement 87% de la charge a été transférée à la capacité **34** de l'étage de sortie **14.**

Comme on peut le constater, selon l'invention, la totalité de la charge a été transférée à la fin de la phase d'amplification **62.**

En effet, lors de la première sous-phase **64,** l'amplificateur **16** est déconnecté de l'étage de sortie **14,** et donc de sa capacité **34.** Pendant cette première sous-phase **64,** la capacité équivalente $C_{eq}$ est sensiblement égale à 12 picofarads, ce qui donne une constante de temps d'environ 40 nanosecondes. La totalité de la charge convertie est donc bien stockée dans la capacité **18,** étant donné que la première sous-phase **64** dure 250 nanosecondes, durée suffisante pour obtenir le stockage complet.

Lors de la seconde sous-phase **66,** l'amplificateur **16** est déconnecté de l'étage d'entrée **12** et donc de ses capacités **32** et **40.** Pendant cette seconde sous-phase **66,** la capacité équivalente $C_{eq}$ est sensiblement égale à 2,3 picofarads, ce qui donne une constante de temps d'environ 7,7 nanosecondes, la tension $V_{out}$ (représentative de la quantité de charges convertie aux bornes de la capacité de contre-réaction **18)** est ainsi appliquée aux bornes de la capacité **34** de l'étage de sortie **14,** étant donnée la durée de 250 nanosecondes de la sous-phase **66.**

Comme on peut le noter, le temps d'établissement cumulé selon l'invention est d'environ 46,5 nanosecondes. Comparativement au temps d'établissement de 250 nanosecondes de l'état de la technique, un gain supérieur à 5 est obtenu en vitesse de conversion de charge.

Ceci permet notamment de baisser significativement la valeur $g_m$ de la transconductance de l'amplificateur **16,** permettant ainsi une économie d'énergie substantielle. Ceci permet également de concevoir des cycles d'amplification, par exemple des cycles de lecture de la capacité **32** ayant une fréquence plus élevée.

On notera également que ce gain en vitesse est réalisé sans modification de la structure du dispositif de conversion qui reste identique à celui de l'état de la technique.

Les durées des deux phases **64** et **66** composant la phase de conversion **62** sont choisies égales de manière à avoir un pilotage simple des interrupteurs. A la vue du gain en vitesse obtenu, le dispositif selon l'invention peut ainsi être incorporé dans les structures existantes sans étude complémentaire.

En variante, les durées des deux phases **64** et **66** sont choisies en fonction des valeurs de la capacité équivalente $C_{eq}$ lors de celles-ci. Par exemple les durées sont choisies au prorata de ces valeurs

On notera que le choix et l'ordonnancement des signaux de commande appliqués aux interrupteurs **44, 46, 48** et **50** ont pour effet que l'étage d'entrée **12** est non inverseur. L'amplificateur opérationnel **16** contre-réactionné par la capacité **18** étant une structure inverseuse, l'association de l'étage d'entrée **12** et du dispositif de conversion **60** est alors une structure d'amplification de la tension $V_e$ ou de lecture de la capacité $C_{mes}$ qui est inverseuse, comme le montre le signe « - » de la relation (2).

En variante, les signaux de commande des interrupteurs **46** et **48** précédemment décrits sont permutés, l'interrupteur **46** étant donc piloté par le signal de commande $\varphi_1$ et l'interrupteur **48** par le signal de commande $\varphi_{21}$. L'étage d'entrée **12** est alors inverseur.

L'amplificateur opérationnel **16** contre-réactionné par la capacité **18** étant une structure inverseuse, le gain en continu est alors donné par relation (2) sans le signe « - ». L'association de l'étage d'entrée **12** et du dispositif de conversion **60** est ainsi une structure d'amplification de la tension $V_e$ ou de lecture de la capacité $C_{mes}$ qui est non inverseuse.

En variante, l'interrupteur **46** (ou l'interrupteur **48** dans la version "inverseuse" de l'étage **12** décrite ci-dessus) situé dans l'étage d'entrée **12** est commandé par un signal de commande analogue au signal $\varphi_2$ décrit en liaison avec le dispositif de l'état de la technique de la figure 1, au lieu d'être commandé par le signal de commande $\varphi_{21}$ qui pilote la connexion/déconnexion du dispositif de conversion **60** de l'étage d'entrée **12**.

En variante, dans l'un ou l'autre des étages d'entrée précités (inverseur ou non inverseur), l'interrupteur **42** du dispositif de conversion de charge **60** est omis afin de sommer dans ce même dispositif **60** les différentes conversions des stimuli d'entrée ($V_e$ ou $C_{mes}$) échantillonnées dans l'étage d'entrée **12**. Il est ainsi obtenu la fonction d'intégration en plus de la fonction d'amplification.

Avantageusement, l'interrupteur **44** est placé au plus près du noeud auquel sont connectés le condensateur **18** et la borne inverseuse **20** de l'amplificateur opérationnel **16**. L'ouverture de l'interrupteur **44** déconnecte ainsi le maximum de connectique de ces éléments effectivement en charge de l'amplification de charge.

Pour les mêmes raisons, l'interrupteur **52** est placé au plus près du noeud auquel sont connectés le condensateur **18** et la borne de sortie de l'amplificateur opérationnel **16**.

Les capacités équivalentes dans chaque phase de connexion/déconnexion selon l'invention sont ainsi optimisées.

Il a été décrit une application de l'invention dans laquelle il n'y a qu'un seul étage d'entrée et un seul dispositif de conversion.

L'invention s'applique également à la conversion de charge dans une matrice **100** de pixels d'image **120₁₁**-**120_{LC}** agencés en L lignes par C colonnes. Pour chaque colonne de la matrice **100,** les L pixels **120₁ⱼ**-**120_{Lj}** sont reliés via L interrupteurs **44₁ⱼ**-**44_{Lj}** à un bus colonne **31ⱼ** qui présente une capacité parasite **40ⱼ** par rapport à la masse. Chacun de ces C ensembles **120₁₁**-**120_{LC}**, **44₁ⱼ**-**44_{Lj}**, **31ⱼ** et **40ⱼ** constitue un étage d'entrée **12ⱼ.** La matrice **100** se décompose donc en C étages d'entrée **12₁**-**12_C**.

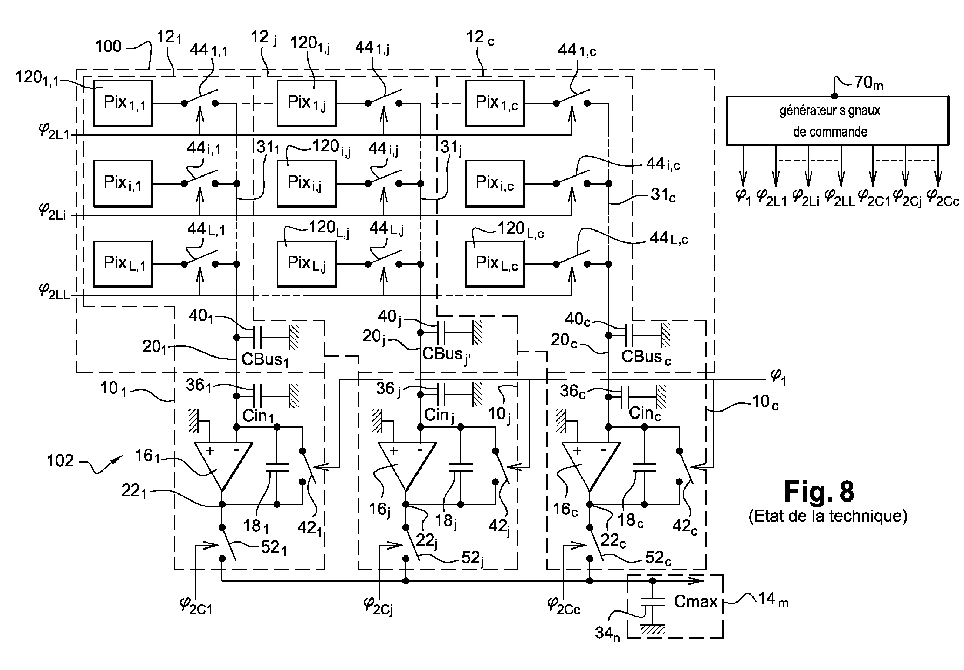

Un convertisseur de charges **102** de l'état de la technique est illustré à la figure 8.

Le convertisseur de charges **102** de l'état de la technique comporte C dispositifs de conversion de charges **10₁**-**10_C**. Chacun de ces dispositifs de conversion **10₁**-**10_C** est connecté à un des étage d'entrée **12₁**-**12_C** constituant la matrice de pixels **100** et est apte à être connecté à un étage de sortie unique **14_m** constitué d'un multiplexeur colonne de capacité $C_{mux}$.

Le dispositif de conversion **10₁**-**10_C** comprend un amplificateur **16₁**-**16_C** contre-reactionné par une capacité **18₁**-**18_C** de valeur $C_{fbj}$ et connectée entre la borne inverseuse **20₁**-**20_C** et la sortie **22₁**-**22_C** de l'amplificateur, un premier interrupteur pilotable **42₁**-**42_C** connecté en parallèle de la capacité **18₁**-**18_C**, L deuxièmes interrupteurs pilotables, **44₁,₁**-**44_{L,C}** aptes à connecter la borne inverseuse **20₁**-**20_C** de l'amplificateur **16₁**-**16_C** à chacun des pixels de la colonne, et un troisième interrupteur pilotable **52₁**-**52_C** connecté à la sortie **22₁**-**22_C** de l'amplificateur.

Enfin, un générateur **70_m** de signaux de commande est également prévu pour le pilotage des premier, deuxièmes et troisième interrupteurs **42₁**-**42_C**, **44₁,₁**-**44_{L,C}**, **52₁**-**52_C**. Plus particulièrement, le générateur **70_m** pilote les premiers interrupteurs **42₁**-**42_C** au moyen d'un signal $\varphi_1$, les C deuxièmes interrupteurs **44₁,₁**-**44_{L,C}** d'une même ligne de la matrice **100** respectivement au moyen d'un signal $\varphi_{2L1}$ - $\varphi_{2LL}$, et chacun des troisièmes interrupteurs **52₁**-**52_C** respectivement au moyen d'un signal $\varphi_{2C1}$ - $\varphi_{2CC}$.

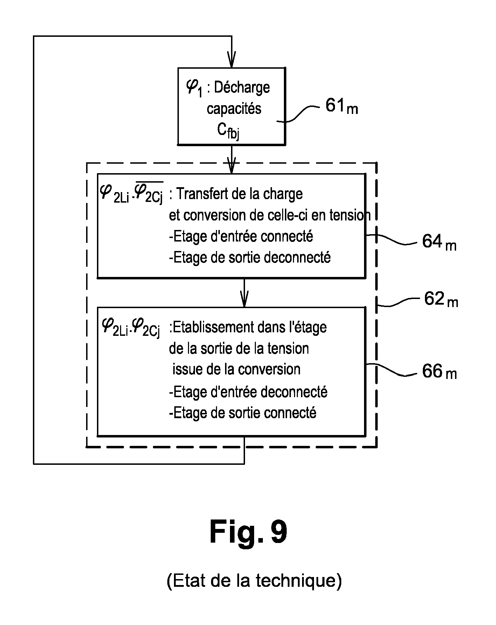

Le fonctionnement du convertisseur de charge **102** de l'état de la technique est illustré par les figures 9 à 17.

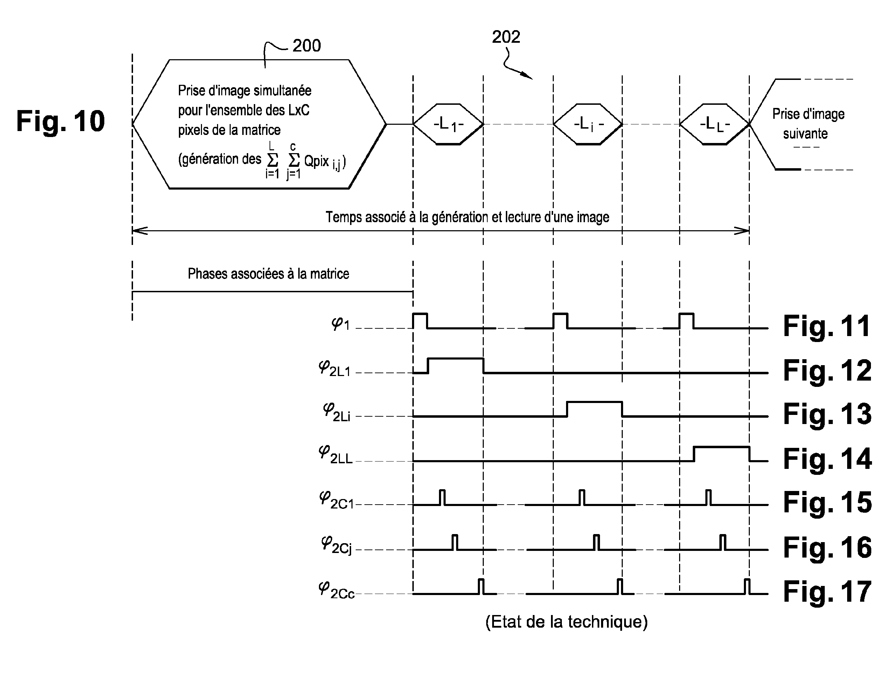

Comme cela est visible à la figure 11, une trame dite « de lecture » de la matrice **100** se compose d'une première phase **200** d'exposition de celle-ci à un rayonnement, pendant laquelle des charges sont générées dans les pixels **120₁₁**-**120_{LC}**, suivie d'une phase **202** de lecture desdites charges. Lors de la phase de lecture **202,** la matrice **100** est lue ligne de pixels par ligne de pixels et comprend ainsi L phases successives de lecture de lignes **L₁**-**L_L**.

Comme cela est visible sur les figures 11 à 17, lors d'une phase d'initialisation de la lecture d'une ligne de pixels de la matrice **100,** les C premiers interrupteurs **42₁**-**42_C** sont fermés pour décharger les condensateurs **18₁**-**18_C** et les seconds et troisièmes interrupteurs **44₁,₁**-**44_{L,C}**, **52₁**-**52_C** sont ouverts.

Lors d'une deuxième phase de la lecture de la ligne de pixels, les C premiers interrupteurs **42₁**-**42_C** sont ouverts, les deuxièmes interrupteurs **44₁,₁**-**44_{L,C}** associés aux pixels de cette ligne sont fermés et les troisièmes interrupteurs **52₁**-**52_C** en sortie des dispositifs de conversion de charges **10₁**-**10_C** sont successivement fermés momentanément pour le transfert de charge au multiplexeur colonne **14_m**.

On notera ainsi qu'un dispositif de conversion de charges **10₁**-**10_C** réalise la conversion séquentielle des charges produites par L pixels d'une colonne de la matrice **100**.

Toutefois, lors de la conversion de charges, le dispositif de conversion de charges **10₁**-**10_C** est constamment connecté au bus colonne **31₁**-**31_C** et donc à sa capacité parasite $C_{bus1}$-$C_{busC}$. Or, la capacité parasite d'un bus colonne est usuellement très élevée, ce qui se traduit par une capacité équivalente $C_{eq}$ très importante. Cette connexion permanente au bus colonne **31₁**-**31_C** limite ainsi très fortement le temps d'établissement de la conversion de charge en tension.

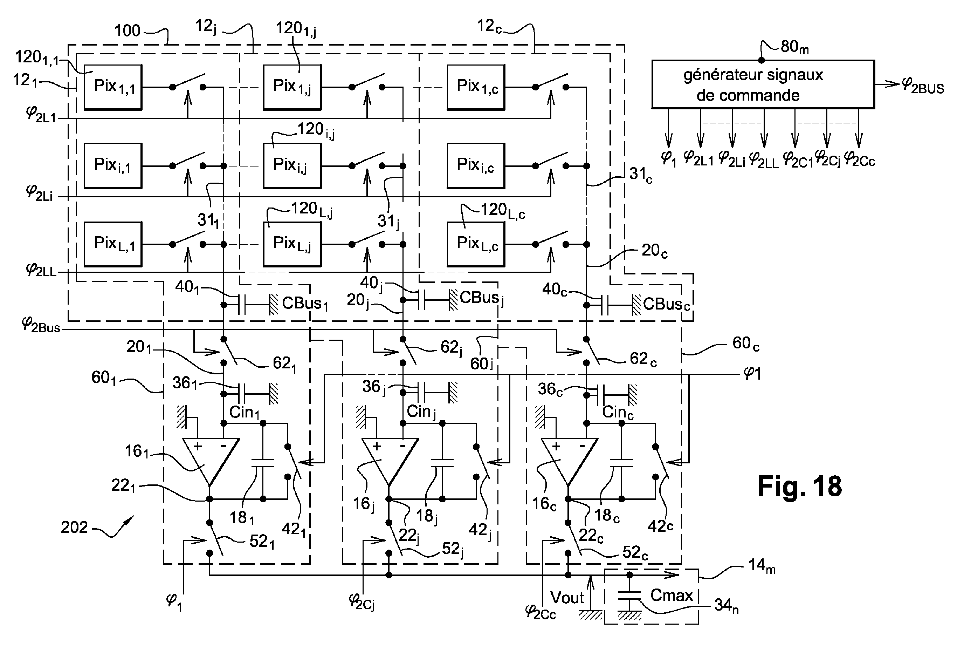

Un convertisseur de charges **302** selon l'invention, illustré à la figure 18, comporte également C dispositifs de conversion de charges **60₁**-**60_C**. Ces dispositifs de conversion de charges **60₁**-**60_C** diffèrent de ceux de l'état de la technique en ce qu'il comporte en outre des quatrièmes interrupteurs pilotables **62₁**-**62_C** respectivement agencés entre les entrées non inverseuses **20₁**-**20_C** des amplificateurs **16₁**-**16_C** et les bus colonnes **31₁**-**31_C**.

Les quatrièmes interrupteurs **62₁-62_C** sont pilotés par un générateur **80_m** de signaux de commande qui diffère du générateur **70_m** de l'état de la technique en ce qu'il produit en outre un signal de pilotage $\varphi_{2BUS}$ des quatrièmes interrupteurs **62₁-62_C**.

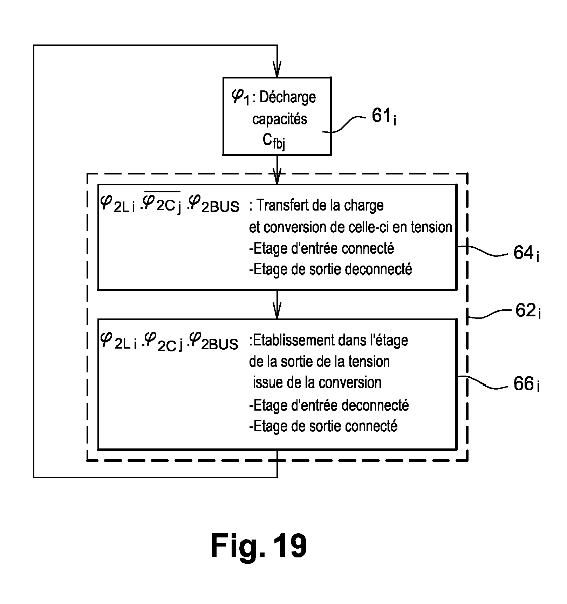

Le fonctionnement du convertisseur de charge **302** selon l'invention est illustré par les figures 19 à 28.

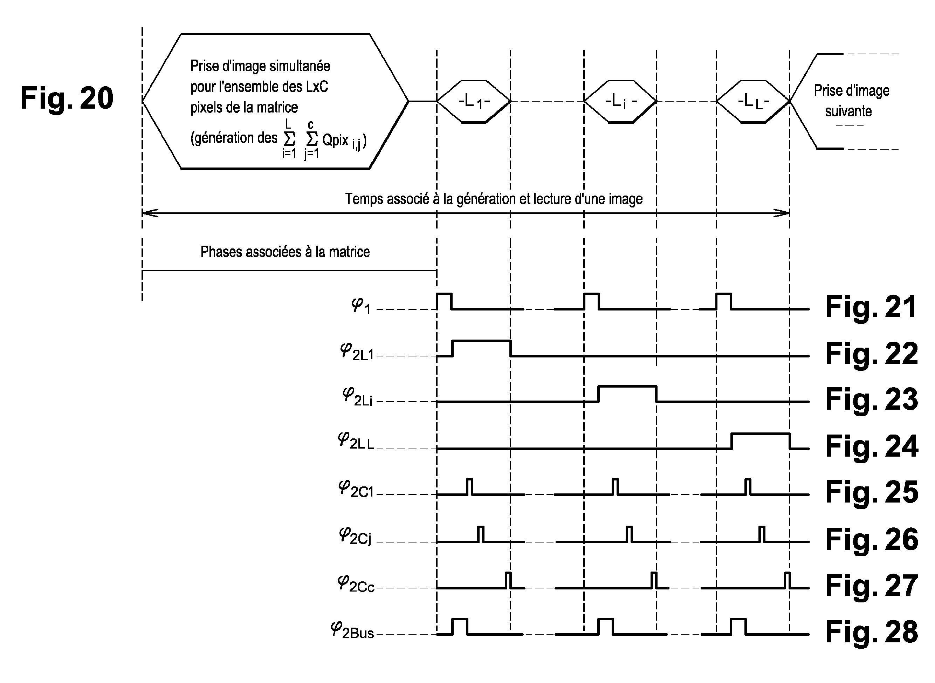

Ce fonctionnement diffère de celui de l'état de la technique illustré aux figures 9 à 17, en ce que l'entrée des dispositifs conversion de charges **60₁-60_C** est déconnectée des bus colonnes **31₁-31_C** préalablement aux transferts de tensions résultantes des conversions de charges stockées aux bornes des capacités **18₁-18_C** au multiplexeur colonne **14_m**. Ceci permet ainsi, lors de établissement séquentiel des tensions $V_{out}$ dans l'étage de sortie **14_m**, d'isoler les dispositifs de conversion de charges **60₁-60_C** de leurs principales capacités parasites d'entrée $C_{bus1}$-$C_{busC}$. Ainsi, comme cela est visible à la figure 28, les interrupteurs **62₁-62_C** sont continuellement ouverts, excepté un intervalle de temps nécessaire au transfert des charges des pixels dans les capacités **18₁-18_C**.

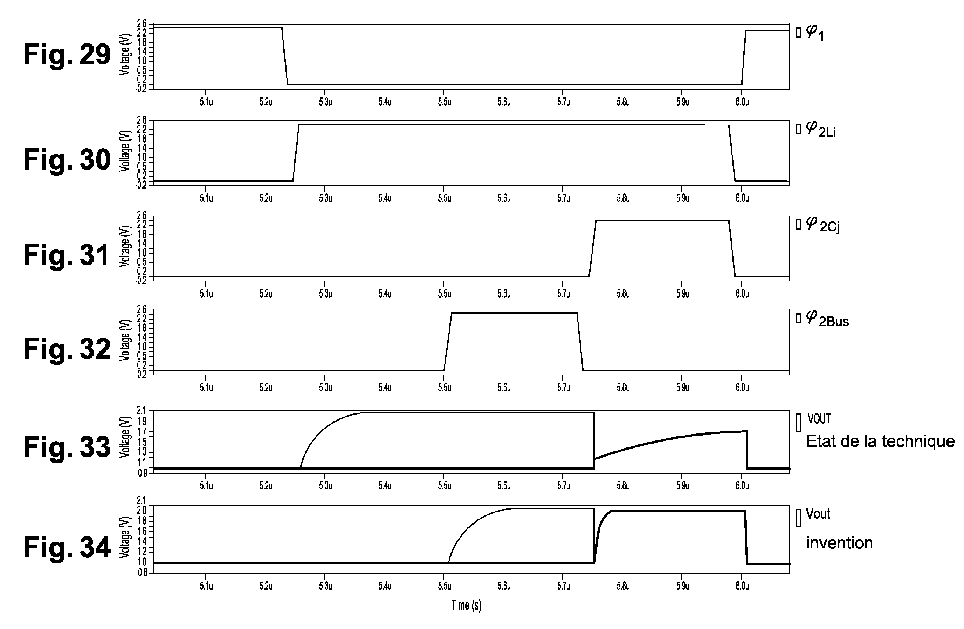

Une réduction très significative du temps d'établissement du dispositif de conversion de charges, ainsi qu'un établissement correct de la tension $V_{out}$ lors de la lecture de la matrice **100,** sont ainsi obtenus, comme cela est illustré aux figures 29 à 34. Les figures 29 à 34 illustrent pour la lecture d'une ligne i de la matrice **100,** la conversion de charge du pixel de la colonne j. Comme on peut le constater à la figure 39, la connexion permanente d'un dispositif de conversion de charges de l'état de la technique à un bus colonne ne permet pas de convertir la totalité de la charge en raison d'un temps d'établissement trop élevée. Par contre, selon l'invention, l'isolement du dispositif de conversion du bus colonne lors de l'établissement de la tension $V_{out}$ dans l'étage de sortie a pour effet une chute significative du temps d'établissement et une conversion complète de la charge.

Pour les mêmes raisons que celles évoquées précédemment en relation avec le dispositif de la figure 2, les interrupteurs **62₁-62_C** et les interrupteurs **52₁-52_C** sont placés au plus près des amplificateurs constitués des amplificateurs opérationnels **16₁-16_C** contre-réactionnés par les capacités **18₁-18_C**.

Il a été décrit un mode de réalisation de l'invention dans lequel N dispositifs de conversion de charges ($10_1$, $10_j$, $10_N$,) assure la conversion des charges d'une matrice de pixels agencés en L lignes par C colonnes avec la particularité N=C du fait d'avoir un dispositif de conversion de charges par colonne.

Bien entendu l'invention s'applique également aux cas où il est nécessaire de mutualiser les dispositifs de conversion de charges pour plusieurs colonnes, dans lesquels on a la relation N=C/M avec M représentant par exemple le nombre de colonnes associées à un dispositif de conversion de charges.

L'invention s'applique également dans les cas où d'associer plusieurs dispositifs de conversion de charges sont associés pour une seule colonne, dans lesquels on a la relation N = C.P avec P représentant par exemple le nombre de dispositifs de conversion de charges par colonne.

Il a été décrit des agencements et des fonctionnements de dispositifs de conversion de charge non différentiels.

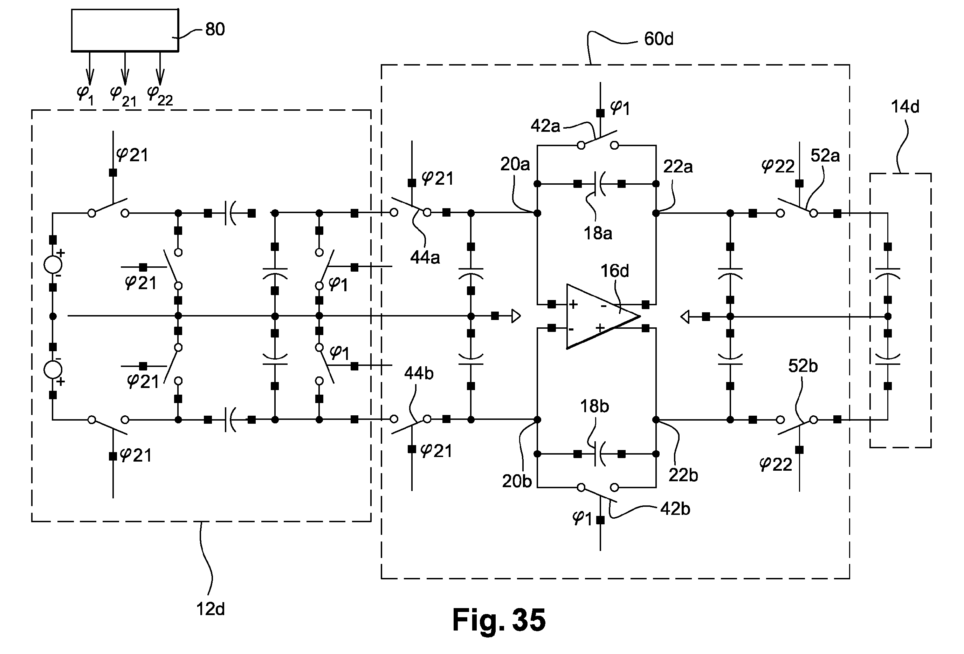

Bien entendu, l'invention s'applique également à la conversion différentielle de charge par un amplificateur différentiel dont chaque sortie est montée en contre-réaction sur une entrée au moyen d'une capacité. Un dispositif **60d** de conversion différentiel de charge est illustré à la figure 35. Ce dispositif **60d** reprend la structure de contre-réaction et d'interrupteurs décrite en relation avec la figure 2 pour chacune des entrées inverseuse et non-inverseuse d'un amplificateur **16d**.

Les deux branches de l'amplificateur sont alors pilotées de manière synchrone selon une phase d'amplification et de stockage des charges dans les capacités de contre-réaction et une phase de transfert des charges stockées à l'étage de sortie décrite en relation avec les figures 2 à 4

Grâce à l'invention, il est ainsi obtenu les avantages suivants :

■ un gain sensible en vitesse de conversion des charges grâce à une diminution des capacités équivalentes ;
■ une indépendance accrue des caractéristiques de la conversion de charges vis-à-vis des étages d'entrée et de sortie ;
■ une modification mineure de la structure des dispositifs de conversion de charge de l'état de la technique ;
■ une possibilité d'augmenter la fréquence de conversion de charge, en diminuant par exemple la durée de lecture d'une matrice de pixels ;
■ une possibilité d'augmenter le gain de conversion charges/tension en conservant la même durée de conversion ; et
■ une possibilité de réduire la consommation et/ou la surface des amplificateurs en diminuant la transconductance $g_m$.

**Revendications**

1. Procédé de pilotage d'un dispositif (60 ; 60d ; 60₁-60_C) de conversion de charges en tension comportant un amplificateur (16 ; 16d ; 16₁-16_C) et au moins une capacité (18 ; 18a, 18b ; 18₁-18_C) montée en contre-réaction entre une entrée (20 ; 20a, 20b ; 20₁-20_C) et une sortie (22 ; 22a, 22b ; 22₁-22_C) dudit amplificateur (16 ; 16d ; 16₁-16_C),

ledit amplificateur (16 ; 16d ; $16_1$-$16_C$) étant apte à être connecté entre au moins un étage d'entrée (12 ; 12d ; $12_1$-$12_C$), pour recevoir de celui-ci au moins une charge, et au moins un étage de sortie (14 ; 14d ; $14_m$) pour délivrer à celui-ci une tension représentative de la charge reçue, ledit procédé comportant au moins une phase de conversion (62) de la charge reçue sur l'entrée, *caractérisé* :

- **en ce que** la phase de conversion comporte au moins :

■ une première sous-phase (64 ; $64_i$) pendant laquelle l'amplificateur (16 ; 16d ; $16_1$-$16_C$) est connecté à l'étage d'entrée (12 ; 12d ; $12_1$-$12_C$) et l'amplificateur (16 ; 16d ; $16_1$-$16_C$) est déconnecté de l'étage de sortie (14 ; 14d ; $14_m$) ;
■ suivie, d'une seconde sous-phase (66 ; $66_i$) pendant laquelle l'amplificateur (16 ; 16d ; $16_1$-$16_C$) est déconnecté de l'étage d'entrée (12 ; 12d ; $12_1$-$12_L$) et l'amplificateur (16 ; 16d ; $16_1$-$16_C$) est connecté à l'étage de sortie (14 ; 14d ; $14_m$),

- et, **en ce que** ledit au moins un étage d'entrée comprend une colonne d'une matrice (100) d'éléments de détection ($120_{11}$-$120_{LC}$), le dispositif ($60_1$-$60_C$) de conversion de charges étant apte à être connecté à chacun des éléments de détection de ladite colonne pour recevoir de celui-ci une charge.

2. Procédé de pilotage selon la revendication 1, *caractérisé* **en ce que** les durées de deux sous-phases (64, 66 ; $64_i$, $66_i$) sont sensiblement identiques.

3. Procédé de pilotage selon la revendication 1, *caractérisé* **en ce que** les durées de deux sous-phases (64, 66 ; $64_i$, $66_i$) sont réglées en fonction des constantes de temps des ensembles formés, d'une part, du dispositif de conversion (60 ; 60d ; $60_1$-$60_C$) connecté à l'étage d'entrée (12 ; 12d; $12_1$-$12_L$), et d'autre part, du dispositif de conversion (60 ; 60d ; $60_1$-$60_C$) connecté à l'étage de sortie (14 ; 14d ; $14_m$).

4. Procédé de pilotage selon l'une des revendications 1, 2 ou 3, *caractérisé* **en ce que** le ou chaque amplificateur (16 ; 16d ; $16_1$-$16_C$) est un amplificateur opérationnel, dont l'entrée inverseuse (20 ; 20a, 20b ; $20_1$-$20_C$) et la sortie (22 ; 22a, 22b ; $22_1$-$22_C$) sont montées en contre-réaction par une capacité (18 ; 18a, 18b ; $18_1$-$18_C$).

5. Procédé de pilotage selon l'une des revendications 1, 2 ou 3, *caractérisé* **en ce que** le ou chaque amplificateur (16d) est un amplificateur différentiel dont chaque entrée (20a, 20b) est montée en contre-réaction avec une sortie (22a, 22b) de l'amplificateur au moyen d'une capacité (18a, 18b).

6. Procédé selon l'une quelconque des revendications précédentes, *caractérisé* **en ce que** l'emplacement de la connexion et de la déconnexion de l'amplificateur (16 ; 16d ; $16_1$-$16_C$) à l'étage d'entrée (12 ; 12d ; $12_1$-$12_C$) et/ou l'emplacement de la connexion et de la déconnexion de l'amplificateur (16 ; 16d ; $16_1$-$16_C$) à l'étage de sortie (14 ; 14d ; $14_m$) est localisé au plus près de l'amplificateur.

7. Système de conversion de charges comportant :

■ un dispositif (60 ; 60d ; $60_1$-$60_C$) de conversion de charge en tension comportant un amplificateur (16 ; 16d ; $16_1$-$16_C$) et au moins une capacité (18 ; 18a, 18b ; $18_1$-$18_C$) montée en contre-réaction entre une entrée (20 ; 20a, 20b ; $20_1$-$20_C$) et une sortie (22 ; 22a, 22b ; $22_1$-$22_C$) dudit amplificateur (16 ; 16d ; $16_1$-$16_C$), ledit amplificateur (16 ; 16d ; $16_1$-$16_C$) étant apte à être connecté entre au moins un étage d'entrée (12 ; 12d ; $12_1$-$12_L$), pour recevoir de celui-ci au moins une charge, et au moins un étage de sortie (14 ; 14d ; $14_m$) pour délivrer à celui-ci une tension représentative de la charge reçue;
■ un premier élément pilotable (44 ; 44a, 44b ; $62_1$-$62_C$) apte à déconnecter l'amplificateur (16 ; 16d ; $16_1$-$16_C$) de l'étage d'entrée (12 ; 12d ; $12_1$-$12_C$) ; et
■ un dispositif de pilotage (80 ; $80_m$) apte à piloter le premier élément pilotable (44 ; 44a, 44b ; $62_1$-$62_C$) selon une phase de conversion (62 ; $62_i$) d'une charge reçue de l'étage d'entrée par l'amplificateur (16 ; 16d ; $16_1$-$16_C$),

*caractérisé* :

- **en ce qu**'il comporte en outre un deuxième élément pilotable (52 ; 52a, 52b ; $52_1$-$52_C$) apte à déconnecter l'amplificateur (16 ; 16d ; $16_1$-$16_C$) de l'étage de sortie (14 ; 14d ; $14_m$), le dispositif de pilotage (80, 80m) étant apte, lors de la phase de conversion, au moins :

■ à piloter (en 64 ; 64$_i$) le premier élément (44 ; 44a, 44b ; 62$_1$-62$_C$) pour connecter l'amplificateur (16 ; 16d ; 16$_1$-16$_C$) à l'étage d'entrée (12 ; 12d ; 12$_1$-12$_C$), et à piloter le deuxième élément (52 ; 52a, 52b ; 52$_1$-52$_C$) pour déconnecter l'amplificateur (16 ; 16d ; 16$_1$-16$_C$) de l'étage de sortie (14 ; 14d ; 14$_m$) ;

■ puis, à piloter (en 66 ; 66$_i$) le premier élément (44 ; 44a, 44b ; 62$_1$-62$_C$) pour déconnecter l'amplificateur (16 ; 16d ; 16$_1$-16$_C$) de l'étage d'entrée (12 ; 12d ; 12$_{11}$-12$_{LC}$) et à piloter le deuxième élément (52 ; 52a, 52b ; 52$_1$-52$_C$) pour connecter l'amplificateur (16 ; 16d ; 16$_1$-16$_C$) à l'étage de sortie (14; 14d ; 14$_m$),

- et en ce que ledit au moins un étage d'entrée comprend une colonne d'une matrice (100) d'éléments de détection (120$_{11}$-120$_{LC}$), le dispositif (60$_1$-60$_C$) de conversion de charge étant apte à être connecté à chacun des éléments de détection de ladite colonne pour recevoir de celui-ci une charge.

8. Système de conversion de charges selon la revendication 7, *caractérisé* **en ce que** le premier élément pilotable (44 ; 44a, 44b ; 62$_1$-62$_C$) et/ou le deuxième élément pilotable (52 ; 52a, 52b ; 52$_1$-52$_C$) est placé au plus près de l'amplificateur (16 ; 16d ; 16$_1$-16$_C$).

Fig. 1

Fig. 2

EP 2 270 978 A1

**Fig. 3**

$\varphi_1$ : Décharge
capacités
$C_{fb}$, $C_{mes}$ — 61

$\varphi_{21}$: Transfert de la charge
et conversion de celle-ci en tension
-Etage d'entrée connecté
-Etage de sortie deconnecté — 64

— 62

$\varphi_{22}$:Etablissement dans l'étage
de la sortie de la tension
issue de la conversion
-Etage d'entrée deconnecté
-Etage de sortie connecté — 66

**Fig. 4**

**Fig. 5**

**Fig. 6**

**Fig. 7**

**Fig. 8**
(Etat de la technique)

$\varphi_1$ : Décharge
capacités
$C_{fbj}$ ⟋ 61$_m$

$\varphi_{2Li} \cdot \overline{\varphi_{2Cj}}$ : Transfert de la charge
et conversion de celle-ci en tension
-Etage d'entrée connecté
-Etage de sortie deconnecté ⟋ 64$_m$

⟋ 62$_m$

$\varphi_{2Li} \cdot \varphi_{2Cj}$ :Etablissement dans l'étage
de la sortie de la tension
issue de la conversion
-Etage d'entrée deconnecté
-Etage de sortie connecté ⟋ 66$_m$

# Fig. 9

(Etat de la technique)

EP 2 270 978 A1

**Fig. 10**

200

202

Prise d'image simultanée pour l'ensemble des LxC pixels de la matrice

(génération des $\sum\limits_{i=1}^{L}\sum\limits_{j=1}^{C} Qpix_{i,j}$)

-L$_1$-   -L$_i$-   -L$_L$-

Prise d'image suivante

Temps associé à la génération et lecture d'une image

Phases associées à la matrice

$\varphi_1$ — **Fig. 11**

$\varphi_{2L1}$ — **Fig. 12**

$\varphi_{2Li}$ — **Fig. 13**

$\varphi_{2LL}$ — **Fig. 14**

$\varphi_{2C1}$ — **Fig. 15**

$\varphi_{2Cj}$ — **Fig. 16**

$\varphi_{2Cc}$ — **Fig. 17**

(Etat de la technique)

Fig. 18

EP 2 270 978 A1

18

$\varphi_1$ : Décharge
capacités
$C_{fbj}$

$61_i$

$\varphi_{2Li}.\overline{\varphi_{2Cj}}.\varphi_{2BUS}$ : Transfert de la charge
et conversion de celle-ci en tension
-Etage d'entrée connecté
-Etage de sortie deconnecté

$64_i$

$62_i$

$\varphi_{2Li}.\varphi_{2Cj}.\varphi_{2BUS}$ :Etablissement dans l'étage
de la sortie de la tension
issue de la conversion
-Etage d'entrée deconnecté
-Etage de sortie connecté

$66_i$

# Fig. 19

**Fig. 20**

Prise d'image simultanée pour l'ensemble des LxC pixels de la matrice

(génération des $\sum_{i=1}^{L} \sum_{j=1}^{c} Qpix_{i,j}$)

-L₁-  -Lᵢ-  -L_L-  Prise d'image suivante

Temps associé à la génération et lecture d'une image

Phases associées à la matrice

$\varphi_1$ — **Fig. 21**

$\varphi_{2L1}$ — **Fig. 22**

$\varphi_{2Li}$ — **Fig. 23**

$\varphi_{2LL}$ — **Fig. 24**

$\varphi_{2C1}$ — **Fig. 25**

$\varphi_{2Cj}$ — **Fig. 26**

$\varphi_{2Cc}$ — **Fig. 27**

$\varphi_{2Bus}$ — **Fig. 28**

EP 2 270 978 A1

Fig. 29

$\varphi_1$

Fig. 30

$\varphi_{2Li}$

Fig. 31

$\varphi_{2Cj}$

Fig. 32

$\varphi_{2Bus}$

Fig. 33

VOUT

Etat de la technique

Fig. 34

Vout

invention

Time (s)

EP 2 270 978 A1

Fig. 35

Europäisches
Patentamt

European
Patent Office

Office européen
des brevets

**RAPPORT DE RECHERCHE EUROPEENNE**

Numéro de la demande

EP 10 18 4210

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 1 515 541 A (3DV SYSTEMS LTD [IL]) 16 mars 2005 (2005-03-16) * alinéa [0056] - alinéa [0068]; figure 1A * ----- | 1-8 | INV. H03F3/08 H03F3/00 H03F3/72 |
| A | US 5 488 415 A (UNO MASAYUKI [JP]) 30 janvier 1996 (1996-01-30) * colonne 5, ligne 45 - colonne 6, ligne 37; figure 4 * ----- | 1-8 | |
| A | YAZDI N ET AL: "Precision readout circuits for capacitive microaccelerometers" SENSORS, 2004. PROCEEDINGS OF IEEE VIENNA, AUSTRIA OCT. 24 - 27, 2004, PISCATAWAY, NJ, USA,IEEE, 24 octobre 2004 (2004-10-24) , pages 28-31, XP010793325 ISBN: 978-0-7803-8692-1 * page 31, colonne de gauche, alinéa 2; figure 4 * ----- | 1-8 | |
| A | US 5 705 807 A (THRONGNUMCHAI KRAISORN [JP] ET AL) 6 janvier 1998 (1998-01-06) * colonne 14, ligne 21 - colonne 16, ligne 18; figure 9 * ----- | 1-8 | **DOMAINES TECHNIQUES RECHERCHES (IPC)** H03F |
| A | US 2006/158542 A1 (MIZUNO SEIICHIRO [JP] ET AL) 20 juillet 2006 (2006-07-20) * alinéa [0058] - alinéa [0065]; figure 6 * ----- | 1-8 | |

Le présent rapport a été établi pour toutes les revendications

| Lieu de la recherche | Date d'achèvement de la recherche | Examinateur |
|---|---|---|
| Munich | 19 octobre 2010 | Lorenzo, Carlos |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.............................................................................

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 18 4210

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-10-2010

| Document brevet cité au rapport de recherche | | Date de publication | Membre(s) de la famille de brevet(s) | | Date de publication |
|---|---|---|---|---|---|
| EP 1515541 | A | 16-03-2005 | AUCUN | | |
| US 5488415 | A | 30-01-1996 | AUCUN | | |
| US 5705807 | A | 06-01-1998 | AUCUN | | |
| US 2006158542 | A1 | 20-07-2006 | CN | 1820498 A | 16-08-2006 |
| | | | EP | 1732315 A1 | 13-12-2006 |
| | | | JP | 4421353 B2 | 24-02-2010 |
| | | | JP | 2005295336 A | 20-10-2005 |
| | | | WO | 2005096622 A1 | 13-10-2005 |
| | | | KR | 20060130547 A | 19-12-2006 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **N. Yazdi et al.** Precision readout circuits for capacitive microaccelerometers. *Sensors 2004, Proceedings of IEEE.*, 2004